# EUROPÄISCHE PATENTSCHRIFT

(11) **EP 2 019 424 B1**
(45) Veröffentlichungstag und Bekanntmachung des Hinweises auf die Patenterteilung: **23.11.2016**
(21) Anmeldenummer: 08012360.7
(22) Anmeldetag: 09.07.2008
(51) Int. Cl.: H01L 23/24, H01L 23/10, H01L 21/50, H01L 23/40, H01L 21/48, H01L 25/07

(54) **Leistungshalbleitermodul mit Dichteinrichtung zum Substratträger und Herstellungsverfahren hierzu**
High performance semiconductor module with sealant device on substrate carrier and corresponding production method
Module semi-conducteur de puissance doté d'un dispositif étanche destiné au support de substrat et son procédé de fabrication

(30) Priorität: 26.07.2007 DE 102007034848
(43) Veröffentlichungstag der Anmeldung: 28.01.2009
(73) Patentinhaber: SEMIKRON Elektronik GmbH & Co. KG, 90431 Nürnberg (DE)
(72) Erfinder: Kroneder, Christian, 90596 Schwanstetten (DE)

(56) Entgegenhaltungen:
- EP-A1- 0 398 108
- EP-A2- 0 447 884
- DE-A1- 4 439 471
- DE-A1- 10 139 287
- DE-A1- 10 340 974

## Beschreibung

Die Erfindung beschreibt ein Leistungshalbleitermodul mit einem Gehäuse, mindestens einem vorzugsweise in einer Aussparung des Gehäuses angeordneten und von dem Gehäuse seitlich umschlossenen Substratträger mit einer hierauf ausgebildeten leistungselektronischen Schaltungsanordnung und von dieser ausgehenden elektrischen Anschlusselementen.

Beispielhaft ist in der DE 101 00 460 A1 ein Leistungshalbleitermodul der genannten Art offenbart, wie es in seiner Grundausprägung seit langem bekannt ist. Derartige Leistungshalbleitermodule gemäß dem Stand der Technik weisen einen Substratträger auf, der den unteren Abschluss des Leistungshalbleitermoduls bildet. Das Isolierstoffgehäuse überragt hierbei diesen Substratträger an seinen Längsseiten geringfügig um ihn zu umschließen. Derartige Substratträger sind häufig ausgebildet als ein flächiger Metallformkörper, vorzugsweise aus Kupfer. Hierdurch ist ein geringer Wärmewiderstand bei wirksamer Wärmespreizung für den Wärmetransport von der leistungselektronischen Schaltungsanordnung zu einem Kühlbauteil gegeben.

Die EP 0398108 A1 beschreibt ein Leistungshalbleitermodul mit einem Kunststoffgehäuse, das eine Ausnehmung in einer Bodenebene aufweist, die zur Aufnahme eines Substrats dient. Das Substrat wird mittels eines elastischen Klebstoffes, welcher in die Ausnehmung angebracht ist, befestigt, so dass es nahezu bündig mit der Bodenebene abschließt.

In der DE 101 39 287 A1 wird ein Leistungshalbleitermodul mit einer Keramikplatte beschrieben. Die Keramikplatte ist auf eine elektrische Dichtung aufgesetzt und zwischen einer Zwischenplatte und einem Kühler angebracht.

Aus der DE 103 40 974 A1 ist eine Steuergeräteeinheit offenbart, bei der elektrische Leiterbahnen durch eine im Rahmen umlaufende Nut verlaufen. Eine Anformung eines Deckels ist in die Nut derart eingesetzt, dass die Stirnfläche der Anformung in Kontakt mit einem Dichtgel gelangt.

Die EP 0 477 884 A2 beschreibt eine Halbleitervorrichtung mit einem Leiterelement, das zwischen einer Klebeschicht und einem härtbarem Epoxid angeordnet ist und mit einem elektronischen Bauelement verbunden ist. Ein Deckel dichtet mit einer Grundplatte ab mittels UV-Bestrahlung.

Die DE 44 39 471 A1 offenbart eine Baugruppe, insbesondere für Kraftfahrzeuge, bestehend aus einem ein- oder mehrteiligen Gehäuse, einer mit dem Gehäuse einstückig ausgebildeten Steckereinheit mit Anschlußstiften und einer Leiterplatte zur Aufnahme von Bauelementen, wobei die Leiterplatte derart ausgebildet und angeordnet ist, daß die Anschlußstifte der Steckereinheit direkt auf oder in die Leiterplatte geführt werden.

Gemäß dem Stand der Technik ist weiterhin bekannt, dass der Substratträger mit dem Gehäuse verklebt ist, um bei einer Befüllung des Gehäuses mit einem zu diesem Zeitpunkt flüssigen Isolierstoff, beispielhaft einem Silikonkautschuk, ein Ausfließen diese Silikonkautschuks zu verhindern. Weiterhin ist das Gehäuse mittels metallischer Nietverbindungen mit dem Substratträger verbunden. Diese Nietverbindungen sind als Hohlkörper mit einer durchgehenden Ausnehmung ausgebildet um ebenso eine Befestigung des Leistungshalbleitermoduls auf einem Kühlbauteil mittels einer Schraubverbindung zu ermöglichen. Gemäß dem Stand der Technik sind diese Nietverbindungen als Messingnieten ausgebildet, da diese auf Grund des Bleianteils des Messings eine gewisse Verformung ermöglichen und somit eine Nietverbindung erst möglich machen.

Auf dem Substratträger selbst ist isoliert von diesem die Schaltungsanordnung des Leistungshalbleitermoduls angeordnet. Hierbei sind verschiedene Schaltungsanordnungen mit Leistungstransistoren, Leistungsdioden und / oder Leistungsthyristoren bekannt. Die Schaltungsanordnung ist mittels isolierender Substrate, beispielhaft DCB- (direct copper bonding) Substrate, von dem Substratträger isoliert.

Weiterhin dem Stand der Technik zuzuordnen sind verschieden ausgestaltete Anschlusselemente für Last- und Hilfsanschlüsse, beispielhaft Steueranschlüsse für gesteuerte Leistungshalbleiterbauelemente. Hierbei sind verschiedene Verbindungstechnologien dieser Anschlusselemente mit dem Substrat oder den Leistungshalbleiterbauelementen der Schaltungsanordnung bekannt. Besonders bevorzugt sind hierbei Lötverbindungen, Druckkontaktverbindungen und / oder Drucksinterverbindungen.

Nachteilig an Leistungshalbleitermodulen gemäß dem Stand der Technik ist, dass der Substratträger mittels einer Klebeverbindung mit dem Gehäuse verbunden ist, um während des Herstellungsprozesses eine Dichtigkeit des Gehäuses gegen Ausfließen des Silikonkautschuks zu gewährleisten. Die dauerhaft haltbare Verbindung wird zusätzlich durch oben beschriebene Nietverbindung erreicht.

Der Erfindung liegt somit die Aufgabe zugrunde ein Leistungshalbleitermodul mit einem Substratträger vorzustellen, wobei dieser mit Verbindungsmitteln mit dem Gehäuse des Leistungshalbleitermoduls zusammengefügt ist und wobei das zugehörige Herstellungsverfahren einer kostengünstigen und automatisierbaren Ausgestaltung zugänglich ist.

Diese Aufgabe wird erfindungsgemäß gelöst, durch einen Gegenstand mit den Merkmalen des Anspruchs 1 sowie durch ein Verfahren gemäß Anspruch 6. Bevorzugte Ausführungsformen sind in den Unteransprüchen beschrieben.

Den Ausgangspunkt der Erfindung bildet ein Leistungshalbleitermodul mit einem Gehäuse, mindestens einem vorzugsweise in einer Aussparung des Gehäuse angeordneten und von dem Gehäuse seitlich, vorzugsweise allseits, umschlossenen Substratträger. Auf diesem Substratträger ist eine leistungselektronische Schaltungsanordnung ausgebildet, von welcher elektrische Anschlusselemente für Last- und Hilfsanschlüsse ausgehen. Es ist hierbei bevorzugt, wenn zumindest ein Anschlusselement als Federkontakteinrichtung ausbildet ist. Weiterhin weist das Gehäuse Befestigungsmittel zur dauerhaften Verbindung mit dem Substratträger auf. Der Substratträger bildet somit eine dem Kühlbauteil zugewandte Außenseite oder den Teil einer Außenseite des Leistungshalbleitermoduls.

Erfindungsgemäß weist das Gehäuse, vorzugsweise die Ausnehmung des Gehäuses, eine einstückig mit diesem ausgebildete Dichteinrichtung auf. Diese Dichteinrichtung ist vorzugsweise in der Aussparung des Gehäuses angeordnet und ist umlaufend und zu einer ersten inneren Hauptfläche des Substratträgers hin ausgebildet. Erfindungsgemäß ist die Dichteinrichtung hierbei ausgebildet aus einem zweiten dauerelastischen Kunststoff.

Das erfindungsgemäße Verfahren zur Herstellung eines derartigen Leistungshalbleitermoduls weist folgende wesentliche Verfahrensschritte auf:
- Ausbildung eines Gehäuses, vorzugsweise mit mindestens einer Ausnehmung für einen zugeordneten Substratträger, in einem Zwei- Komponenten- Spritzverfahren aus einem ersten mechanisch stabilen Kunststoff und einer Dichteinrichtung aus einem zweiten dauerelastischen Kunststoff.
- Anordnung des mindestens einen Substratträgers am Gehäuse, vorzugsweise in der zugeordneten Ausnehmung des Gehäuses.
- Dauerhafte Verbindung des Gehäuses mit dem Substratträger mittels des Befestigungsmittels.

Vorzugsweise wird diese Verbindung ausgebildet, indem das Befestigungsmittel aus Fortsätzen des Gehäuses besteht, die durch Ausnehmungen des Substratträgers hindurch reichen und indem durch Verformung mittels Einwirkung von Temperatur und / oder Ultraschall der Enden dieser Fortsätze eine Nietverbindung hergestellt wird. Es ist hierbei bevorzugt, wenn die Dichteinrichtung die Befestigungsmittel des Substratträgers zumindest teilweise umschließt und zur Aussparung hin ausschließt. Somit ist eine dichte Ausbildung dieser Nietverbindung dahingehend dass diese bei der Befüllung des Leistungshalbleitermoduls mit einem Silikonkautschuk ein Ausfließen verhindert, unnötig.

Es kann weiterhin besonders bevorzugt sein, wenn der Substratträger in seiner Funktionalität durch das Substrat selbst ersetzt wird. Hierbei bildet das Substrat die Begrenzung des Leistungshalbleitermoduls und weist seinerseits die notwendigen Ausnehmungen für die Nietverbindung auf.

Besonders bevorzugte Weiterbildungen dieses Halbleiterbauelements sind in der jeweiligen Beschreibung der Ausführungsbeispiele genannt. Die erfinderische Lösung wird zudem an Hand der Ausführungsbeispiele und der Fig. 1 bis 4 weiter erläutert.
Fig. 1 zeigt ein Gehäuse ohne Substratträger eines erfindungsgemäßen Leistungshalbleitermoduls in dreidimensionaler Ansicht.
Fig. 2 zeigt ein Gehäuse gemäß Fig. 1 in zweidimensionaler Ansicht.
Fig. 3 zeigt einen Querschnitt durch ein Gehäuse eines erfindungsgemäßen Leistungshalbleitermoduls gemäß Fig. 1.
Fig. 4 zeigt im Querschnitt einen Teil des erfindungsgemäßen Leistungshalbleitermoduls gemäß Fig. 1 mit angeordnetem Substratträger.

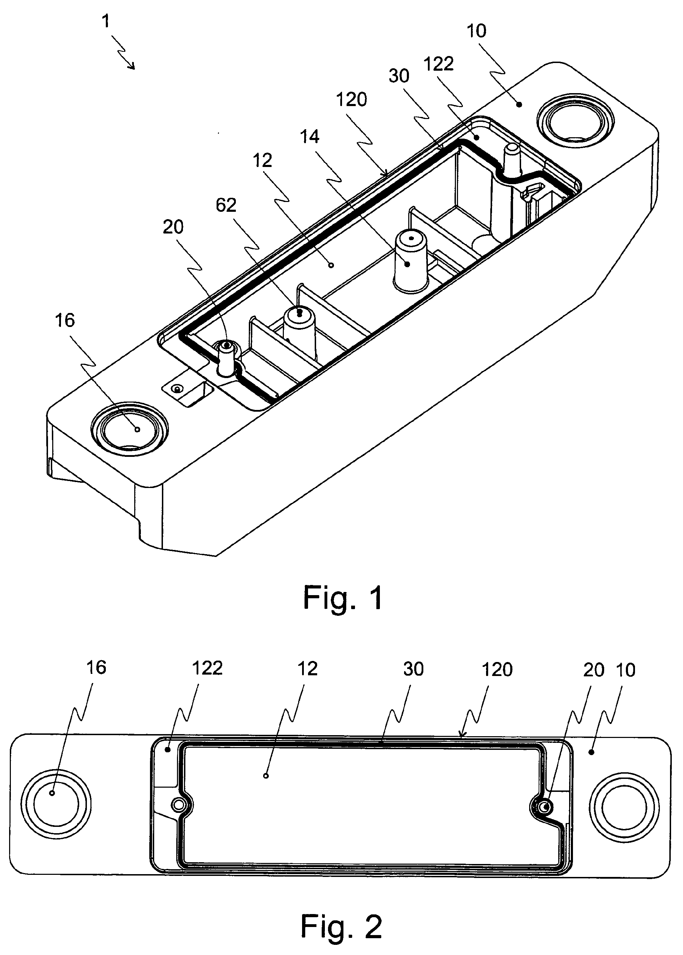

Fig. 1 zeigt ein Gehäuse (10), vorzugsweise aus einem bis über 150°C temperaturstabilen Kunststoff ohne Substratträger eines erfindungsgemäßen Leistungshalbleitermoduls (1) in dreidimensionaler Ansicht. Das Gehäuse (10) weist hierbei an derjenigen Seite die einer nicht dargestellten Kühleinrichtung zugewandt ist eine Aussparung (12) zur Aufnahme eines Substratträgers, sowie zwei Durchführungen (16) für Schraubverbindungen mit dem Kühlbauteil auf. Diese Aussparung (12) weist hierbei vorteilhafterweise an den beiden Längsseiten des Leistungshalbleitermoduls (1) jeweils einen Steg (120) auf, um den anordenbaren Substratträger an allen Seiten zu umschließen

Im Inneren des Leistungshalbleitermoduls (1) sind weitere Durchführungen (14) zur Anordnung von Anschlusselementen, hier von als Kontaktfedern ausgebildeten Hilfsanschlusselementen dargestellt. Diese Hilfsanschlusselemente dienen dem externen Anschluss einer Schaltungsanordnung, die auf einem Substratträger angeordnet ist, der in der Aussparung (12) des Gehäuses (10) anordenbar ist.

Im Bereich dieser Aussparung (12), vorteilhafterweise in ihrem Randbereich (122) der Schmalseiten weist das Gehäuse (10) vorzugsweise einstückig mit diesem ausgebildete Fortsätze (20) auf. Diese Fortsätze (20) sind hier zapfenartig ausgebildet und überragen das Gehäuse (10) in Richtung des anzuordnenden Substratträgers.

Weiterhin dargestellt ist eine Dichteinrichtung (30) aus einem elastischen Kunststoff, der vorzugsweise in einem Zwei- Komponenten- Spritzverfahren gemeinsam mit dem Gehäuse (10) hergestellt wurde. Diese Dichteinrichtung (30) bildet eine im Randbereich der Aussparung (12) des Gehäuses (10) umlaufende Dichtlippe, die in bevorzugter Weise die Fortsätze (20) geeignet umschließt, derart dass sich diese Fortsätze (20) außerhalb des Dichtbereichs der Dichtlippe befinden.

Fig. 2 zeigt ein Gehäuse (10) eines Leistungshalbleitermoduls (1) gemäß Fig. 1 in zweidimensionaler Ansicht, hier in Draufsicht auf die Aussparung (12) zur Anordnung des Substratträgers, ohne Details im Inneren der Aussparung. Dargestellt ist hier wiederum das Gehäuse (10) mit den beiden Durchführungen (16) zur Schraubverbindung mit einem anordenbaren Kühlbauteil. Im Bereich der Aussparung (12) sind weiterhin die Fortsätze (20) des Gehäuses (10) zur Nietverbindung mit dem anordenbaren Substratträger dargestellt.

Im Inneren der Aussparung (12) ist die erfindungsgemäße Dichteinrichtung (30) angeordnet. Diese ist vorteilhafterweise derart angeordnet, dass sie Verbindungsmittel wie die Fortsätze (20) ausspart. Die Fortsätze (20) liegen somit in einem Bereich der Aussparung (12), die nicht von der Dichteinrichtung (30) zum Substratträger hin abgedichtet wird. Dies ist vorteilhaft, da hierdurch die Nietverbindung zwischen den Fortsätzen (20) und dem Substratträger keine besonderen Anforderungen an die Dichtheit aufweisen müssen.

Es kann allerdings auch bevorzugt sein ausschließlich oder zusätzlich Verbindungsmittel im Bereich der zu dichtenden Fläche des Substratträgers anzuordnen, wodurch die Anforderungen an die Nietverbindung dahingehend steigen, dass diese dicht aufgeführt sein muss. Eine elektrisch isolierende Vergussmasse, die während des Herstellungsprozesses in das Innere des Leistungshalbleitermoduls eingebracht wird und dieses zumindest teilweise verfüllt ist, gemäß dem Stand der Technik zu diesem Zeitpunkt noch flüssig und könnte somit im Bereich der Nietverbindungen austreten.

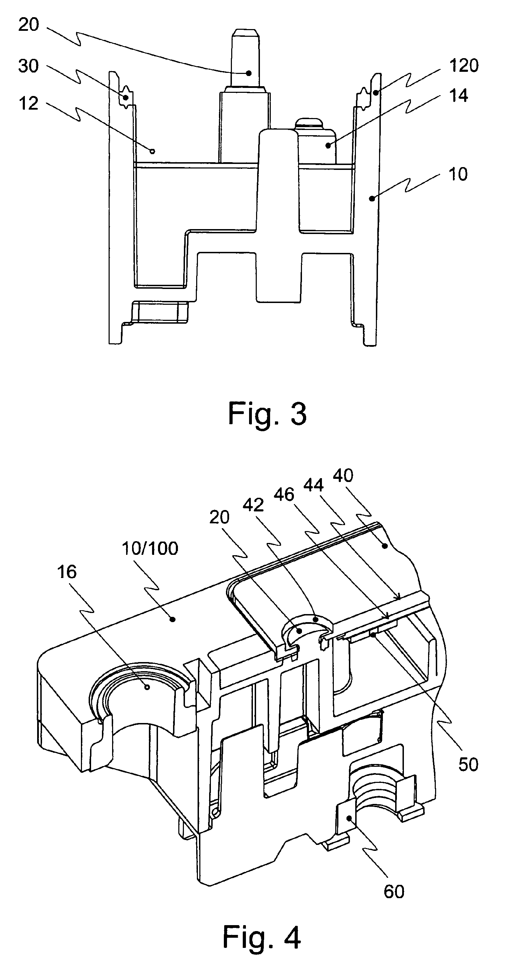

Fig. 3 zeigt einen Querschnitt durch ein Gehäuse (10) eines erfindungsgemäßen Leistungshalbleitermoduls (1) gemäß Fig. 1. Dargestellt ist hier das Gehäuse (10) mit der Aussparung (20) und im Bereich dieser Aussparung angeordnet ein Verbindungsmittel (20) zur Nietverbindung mit einem Substratträger, in Form eines Fortsatzes des Gehäuse (10) und eine Durchführung (14) zur Anordnung eines als Kontaktfeder ausgebildeten Hilfsanschlusselements. Die Aussparung (12) selbst ist seitlich zu den Längsseiten des Leistungshalbleitermoduls (1) begrenzt durch zwei Stege (120), die Anschlagmittel für einen anzuordnenden Substratträger bilden. Direkt benachbart zu diesen Stegen (120) im Inneren der Ausnehmung (12) ist die Dichteinrichtung (30) angeordnet. Diese Dichteinrichtung (30) ist gemäß dem beschrieben Verfahren aus einem zweiten dauerelastische Kunststoff ausgebildet und in einem Zwei- Komponenten- Spritzverfahren gemeinsam mit dem Gehäuse (10) aus einem ersten Kunststoff hergestellt.

Fig. 4 zeigt im Querschnitt einen Teil des erfindungsgemäßen Leistungshalbleitermoduls gemäß Fig. 1 mit angeordnetem Substratträger. Hierbei ist der Substratträger (40) als eine oberflächenveredelte Kupferplatte ausgestaltet. Dieser Substratträger (40) weist fluchtend zu Fortsätzen (20) des Gehäuses (10) durchgehende Ausnehmungen (42) auf. Zur Nietverbindung des Substratträgers mit dem Gehäuse wurden diese Fortsätze mittels Temperatur- und / oder Ultraschallbeaufschlagung derart verformt, dass sie die äußere Hauptfläche (46) des Substratträgers (40) nicht mehr überragen.

Auf der dem Inneren des Leistungshalbleitermoduls (1) zugewandten inneren Hauptfläche (44) des Substratträgers und von diesem elektrisch isoliert ist die leistungselektronische Schaltungsanordnung (50) angeordnet.

## Patentansprüche

1. Leistungshalbleitermodul (1) mit einem Gehäuse (10) aus einem ersten Kunststoff, mindestens einem Substratträger (40) mit einer hierauf ausgebildeten Schaltungsanordnungen (50) und von dieser ausgehenden elektrischen Anschlusselementen (60),
wobei das Gehäuse (10) Befestigungsmittel (20) zur dauerhaften Verbindung mit dem Substratträger (40) aufweist, wobei das Befestigungsmittel (20) aus Fortsätzen des Gehäuses (10) besteht, die durch Ausnehmungen (42) des Substratträgers (40) hindurch reichen und wobei die Fortsätze des Gehäuses (10) mit dem Substratträger (40) eine nietartige Verbindung ausbilden,
wobei das Gehäuse (10) eine einstückig mit diesem ausgebildete und umlaufende und zu einer ersten inneren Hauptfläche (44) des Substratträgers (40) hin gerichtete dauerelastische Dichteinrichtung (30) aus einem zweiten Kunststoff aufweist, wobei der Substratträger (40) in einer Aussparung (12) des Gehäuses (10) angeordnet und von dem Gehäuse (10) seitlich umschlossen ist und die dauerelastische Dichteinrichtung (30) in dieser Aussparung (12) angeordnet ist und wobei die Dichteinrichtung (30) die Befestigungsmittel (20) des Substratträgers (40) zumindest teilweise umschließt und zur Aussparung (12) hin ausschließt.

2. Leistungshalbleitermodul nach Anspruch 1,
wobei der Substratträger (40) als eine oberflächenveredelte Kupferplatte ausgestaltet ist auf deren inneren Hauptfläche (44) eine elektrisch isoliert zur Kupferplatte aufgebaute leistungselektronische Schaltungsanordnung (50) angeordnet ist.

3. Leistungshalbleitermodul nach Anspruch 1,
wobei zumindest ein Anschlusselement (60) als Federkontakteinrichtung ausbildet ist.

4. Verfahren zur Herstellung eines Leistungshalbleitermoduls (1) nach Anspruch 1, mit den Verfahrensschritten:
• Ausbildung eines Gehäuses (10) aus einem ersten mechanisch stabilen Kunststoff und einer Dichteinrichtung (30) aus einem zweiten dauerelastischen Kunststoff und mit einem Befestigungsmittel (20) das aus Fortsätzen des Gehäuses besteht;
• Anordnung des mindestens einen Substratträgers (40) an dem Gehäuse (10), wobei die Fortsätze des Gehäuses durch Ausnehmungen (42) des Substratträgers (40) hindurch reichen;
• Dauerhafte Verbindungen des Gehäuses (10) mit dem Substratträger (40) mittels des Befestigungsmittels (20), indem durch Verformung mittels Einwirkung von Temperatur und / oder Ultraschall der Enden dieser Fortsätze eine Nietverbindung hergestellt wird.

5. Verfahren nach Anspruch 4, wobei anschließend der Innenraum des Leistungshalbleitermoduls (1) zumindest teilweise mit einer elektrisch isolierenden Vergussmasse verfüllt wird.

## Claims

1. Power semiconductor module (1) comprising a housing (10) of a first plastic, at least one substrate carrier (40) with a circuit arrangement (50) constructed thereon and electric terminating elements (60) coming from it,
wherein the housing (10) has attachment means (20) for the permanent connection with the substrate carrier (40), wherein the attachment means (20) consists of projections of the housing (10) which reach through recesses (42) in the substrate carrier (40) and wherein the projections of the housing (10) form a rivet-like connection with the substrate carrier (40),
wherein the housing (10) has a permanently elastic sealing device (30) of a second plastic which is constructed of one piece with the former and circulates and is directed towards a first inner main surface (44) of the substrate carrier (40), wherein the substrate carrier (40) is arranged in a recess (12) of the housing (10) and is laterally enclosed by the housing (10) and the permanently elastic sealing device (30) is arranged in this recess (12) and wherein the sealing device (30) at least partially encloses the attachment means (20) of the substrate carrier (40) and excludes them towards the recess (12).

2. Power semiconductor module according to Claim 1, wherein the substrate carrier (40) is designed as a surface-finished copper plate, on the inner main surface (44) of which a power-electronics circuit arrangement (50), built up electrically insulated to the copper plate, is arranged.

3. Power semiconductor module according to Claim 1, wherein at least one connecting element (60) is constructed as spring contact device.

4. Method for producing a power semiconductor module (1) according to Claim 1, comprising the method steps:
• constructing a housing (10) of a first mechanically stable plastic and a sealing device (30) of a second permanently elastic plastic and having an attachment means (20) which consists of projections of the housing;
• arranging the at least one substrate carrier (40) at the housing (10), wherein the projections of the housing reach through recesses (42) in the substrate carrier (40);
• permanently connecting the housing (10) with the substrate carrier (40) by means of the attachment means (20), by a rivet connection being established by deformation by means of the action of temperature and/or ultrasound of the ends of these projections.

5. Method according to Claim 4, wherein subsequently the internal space of the power semiconductor module (1) is filled at least partially with an electrically insulating casting compound.

## Revendications

1. Module semiconducteur de puissance (1) comprenant un boîtier (10) en une première matière plastique, au moins un porte-substrat (40) sur lequel sont formés des arrangements de circuit (50) et des éléments de raccordement électriques (60) sortant de celui-ci,
le boîtier (10) possédant des moyens de fixation (20) destinés à être reliés à demeure au porte-substrat (40), les moyens de fixation (20) se composant de prolongements du boîtier (10) qui passent à travers des cavités (42) du porte-substrat (40) et les prolongements du boîtier (10) formant avec le porte-substrat (40) une liaison de type rivetée,
le boîtier (10) possédant un dispositif d'étanchéité (30) à élasticité permanente en une deuxième matière plastique, formé d'un seul tenant avec celui-ci et périphérique de celui-ci et orienté vers une première surface principale (44) intérieure du porte-substrat (40), le porte-substrat (40) étant disposé dans une cavité (12) du boîtier (10) et étant entouré latéralement par le boîtier (10) et le dispositif d'étanchéité (30) à élasticité permanente étant disposé dans cette cavité (12) et le dispositif d'étanchéité (30) entourant au moins partiellement les moyens de fixation (20) du porte-substrat (40) et les excluant vers la cavité (12).

2. Module semiconducteur de puissance selon la revendication 1, le porte-substrat (40) étant configuré sous la forme d'une plaque en cuivre à surface affinée et un arrangement de circuit électronique de puissance (50) construit électriquement isolé par rapport à la plaque en cuivre étant disposé sur sa surface principale (44) intérieure.

3. Module semiconducteur de puissance selon la revendication 1, au moins un élément de raccordement (60) étant réalisé sous la forme d'un dispositif de contact à ressort.

4. Procédé de fabrication d'un module semiconducteur de puissance (1) selon la revendication 1, comprenant les étapes de procédé suivantes :
* formation d'un boîtier (10) en une première matière plastique mécaniquement stable et un dispositif d'étanchéité (30) en une deuxième matière plastique à élasticité permanente et comprenant un moyen de fixation (20) qui se compose de prolongements du boîtier ;
* disposition de l'au moins un porte-substrat (40) sur le boîtier (10), les prolongements du boîtier passant à travers des cavités (42) du porte-substrat (40) ;
* assemblage à demeure du boîtier (10) avec le porte-substrat (40) à l'aide du moyen de fixation (20) en réalisant une liaison rivetée par déformation des extrémités de ces prolongements par le biais de l'influence de la température et/ou d'ultrasons.

5. Procédé selon la revendication 4, l'espace intérieur du module semiconducteur de puissance (1) étant ensuite au moins partiellement rempli d'une masse de scellement électriquement isolante.
